# EUROPÄISCHE PATENTSCHRIFT

(11) **EP 3 723 946 B1**
(45) Veröffentlichungstag und Bekanntmachung des Hinweises auf die Patenterteilung: **23.08.2023**
(21) Anmeldenummer: 18819441.9
(22) Anmeldetag: 05.12.2018
(51) Int. Cl.: B25J 9/16

(54) **VERFAHREN ZUR VALIDIERUNG VON PROGRAMMIERTEN ABLAUFSEQUENZEN ODER TEACHPROGRAMMEN DES ROBOTERS IN EINER ARBEITSZELLE SOWIE EINEN ROBOTER UND/ODER ROBOTSTEUERUNG HIERFÜR**
METHOD FOR VALIDATING PROGRAMMED EXECUTION SEQUENCES OR TEACHING PROGRAMS FOR A ROBOT IN A WORKING CELL, AND ROBOT AND/OR ROBOT CONTROLLER FOR SAID METHOD
PROCÉDÉ DE VALIDATION DE SÉQUENCES DE DÉROULEMENT PROGRAMMÉES OU DE PROGRAMMES D'ENSEIGNEMENT D'UN ROBOT DANS UNE CELLULE DE TRAVAIL AINSI QUE ROBOT ET/OU COMMANDE DE ROBOT S'Y RAPPORTANT

(30) Priorität: 14.12.2017 AT 510322017
(43) Veröffentlichungstag der Anmeldung: 21.10.2020
(73) Patentinhaber: Wittmann Technology GmbH, 1220 Wien (AT)
(72) Erfinder: WITTMANN, Peter Michael, 2100 Leobendorf (AT)
(74) Vertreter: Felfernig, Oliver
(86) Internationale Anmeldenummer: PCT/AT2018/060285
(87) Internationale Veröffentlichungsnummer: WO 2019/113618

(56) Entgegenhaltungen:
- US-A1- 2015 151 431
- US-A1- 2015 379 171
- US-B1- 9 811 074

## Beschreibung

Die Erfindung betrifft ein Verfahren zum Validieren von frei programmierten Ablaufsequenzen von Robotern, wobei zu jedem Zeitpunkt zwischen der Validierung am physikalischen Roboter und einem virtuellen Roboter umgeschaltet werden kann, wie es in den Oberbegriffen der Ansprüche 1 und 10 beschrieben ist.

Die Ablaufsequenzen von Industrierobotern werden typischerweise zuerst direkt mit Hilfe der Robotsteuerung programmiert oder an einem externen Rechner erstellt, wobei in diesem Fall in einem zweiten Schritt die physikalischen Positionen im Raum definiert werden müssen. Diese Definitionen können auch im Rahmen der Validierung der Ablaufsequenz erfolgen. Ebenso erfolgt die Validierung der Sequenz für den zukünftigen Automatikbetrieb nach Programmerstellung entweder gleich am physikalischen Roboter oder in zwei separaten Schritten. Im ersten Schritt wird der grundlegende Ablauf der Sequenz offline am externen Rechner, verifiziert und in einem weiteren Schritt am physikalischen Roboter, um die Korrektheit der Positionen und Hardwarefunktionen zu überprüfen.

Nachteilig ist bei der Validierung direkt am Roboter, dass die Achsbewegungen am physikalischen Roboter ausgeführt werden müssen und somit Kollisionen mit Komponenten in der Arbeitszelle auftreten können, auch wenn die Validierung typischerweise mit verminderter Geschwindigkeit ausgeführt wird. Des Weiteren ist diese Validierung auf Programmpfade begrenzt, die durch aktuelle Betriebszustände vorgegeben werden. Bei der Offline-Validierung am externen Rechner hingegen ist die eingeschränkte Visualisierung der tatsächlichen Verhältnisse zu bemängeln, sowie die Anforderung an ein hohes Vorstellungsvermögen des Bedieners an den Gesamtablauf des Roboters im Kontext seiner Umgebung. Das führt nach Übertragung der Ablaufsequenz auf den physikalischen Roboter erneut zu einem erhöhten Kollisionsrisiko beim tatsächlichen Validieren am Objekt.

Weiters ist aus der US 2015/151431 A1 und der US 2015/379171 A1 eine Robotersimulation beschrieben, bei der über eine Ausgabeeinheit eine Ausgabedatei ausgegeben wird, in der die Informationen, die dreidimensionalen Bilder und die Wiedergabeinformationen in ein elektronisches Dokumentformat eingebettet sind. Nachteilig ist auch hier, dass zur Simulation zuerst immer die Daten an ein externes Gerät, insbesondere Computer übertragen werden muss, bevor diese analysiert werden können.

In der US 9 811 074 B1 ist eine beschreibt eine Methodik mit Hilfe von "machine learning" beschrieben, wobei in einer virtuellen Umgebung diverse Robotaufgaben (robotic task) simuliert und auf Erfolg geüberprüfen werden.

Aufgabe der Erfindung ist es daher ein Verfahren für einen Roboter und/oder Robotsteuerung der eingangs genannten Art zu schaffen, mit der einerseits die zuvor beschriebenen Nachteile vermeiden werden und andererseits die Betriebssicherheit der Robotarbeitszelle zu erhöhen.

Die Aufgabe wird durch die Erfindung gelöst.

Das erfindungsgemäße Verfahren ist dadurch gekennzeichnet, dass Verfahrparametern, Ausstattungsmerkmale und Funktionalitäten des physikalischen Roboters steuerungsseitig in einer Konfigurationsdatei gespeichert werden, und die Robotsteuerung aus diesen hinterlegten Daten ein virtuelles Robotmodell erstellt und zur Validierung einer Ablaufsequenz auf das aktuelle Teachprogramm in der Robotsteuerung zurückgreift, wobei die Visualisierung der Ablaufsequenz direkt auf einer Ausgabeeinheit der Robotsteuerung angezeigt wird, wobei das virtuelle Robotmodell in jeder beliebigen Befehlszeile des Teachprogramms vom physikalischen Roboter entkoppelt wird und für die Validierung bestimmter Befehle und Teilsequenzen im Teachprogramm auf potenzielle Kollisionen oder Fehlverhalten verwendet wird, wobei der virtuelle Roboter im gekoppelten Zustand dem physikalischen Roboter folgt und bei Entkopplung diese Synchronisation zwischen virtuellem und physikalischem Roboter gestoppt wird, wobei der gekoppelte physikalische Roboter den aktuellen Programmablauf bis zu einer möglichen Kollisionssituation ausführt und erst dann auf das virtuelle Robotmodell mit Nachstellung von gefährlichen Zuständen umgeschaltet wird, wobei der virtuelle Roboter nach der Entkopplung jederzeit wieder mit dem physikalischen Roboter gekoppelt und in den Ausgangszustand zurückgesetzt wird, um anschließend weitere Teilsequenzen des Teachprogramms zu validieren. Vorteilhaft ist hierbei, dass die Programmerstellung und die Validierung am physikalischen und virtuellen Roboter an einer Stelle, der Ausgabeeinheit der Robotsteuerung vorgenommen werden kann. Damit kann der Maschineneinsteller direkt an der Robotsteuerung und ohne Gefährdung des physikalischen Roboters oder Komponenten in der Arbeitszelle eventuelle Probleme im Ablauf einfach herausfinden und korrigieren. Auch ist es damit möglich, beliebige Zustände von externen Peripherieeingängen in die Robotersteuerung bzw. Robotsteuerung oder weitere Beeinflussungen des Programmablaufes nachzustellen und auszuwählen, um somit Reaktionen des Roboters auf Sonderzustände zu simulieren und den Ablauf in allen Situationen auf Richtigkeit, speziell auf die Vermeidung von Kollisionen, zu testen. Dabei ist es für die einfache Erkennung einer potentiellen Kollision oder falschen Programmierung wichtig, dass der physikalische Roboter den aktuellen Programmablauf möglichst weit bis zu einer möglichen Kollisionssituation ausführt und erst dann auf das virtuelle Robotmodell mit Nachstellung von gefährlichen Zuständen umgeschaltet wird.

Bei der erfindungsgemäßen Lösung kann zu jeder Zeit und in jedem Betriebszustand zwischen der Validierung des physikalischen Roboters und der Validierung und somit Weiterführung des Ablaufes im virtuellen Roboter umgeschaltet werden. Bei dieser Umschaltung wird das virtuelle Robotmodell, welches bisher intern dem physikalischen Modell gefolgt ist, entkoppelt und auf der Ausgabeeinheit der Robotsteuerung im Ablauf beliebig weitergeführt.

Wichtig für eine aussagekräftige und wirkungsvolle Validierung ist, dass das virtuelle Robotmodell auf die Konfigurationsdaten des physikalischen Roboters zugreift und somit alle Funktionen des physikalischen Roboters bereithält, ebenso die korrekten Bewegungsprofile der einzelnen Achsen. Damit lassen sich am virtuellen Robotmodell auch zeitkritische Funktionen und/oder Kombinationen von zeitlich abhängigen Funktionen nachstellen.

Weiters wird erreicht, dass kritische Teilsequenzen des Ablaufes zuerst virtuell auf Richtigkeit überprüft werden und erst anschließend der physikalische Roboter dazu geschaltet wird. Über unkritische, längere Teilsequenzen kann wiederum rasch hinweggefahren werden. Gleichzeitig mit der Validierung kann gegebenenfalls vom Bediener eine optimale Anpassung des programmierten Ablaufes, insbesondere des Teach-In-Programms, vorgenommen werden. Ein wesentlicher Vorteil liegt jedoch darin, dass dadurch die Fehlersuche wesentlich vereinfacht und beschleunigt wird, da der Maschineneinsteller Vorort direkt an der Anlage alles auf der Robotsteuerung betrachten und bewirken und sich somit auf die Validierung von kritischen Stellen im Ablauf fokussieren kann.

Dadurch kann Vorort an der Anlage schnellstmöglich eine Wiederholung verschiedenster Abläufe oder eine Simulation unterschiedlicher Zustände und zur Überprüfung anderer Abläufe zur Optimierung und/oder Fehlersuche vorgenommen werden.

Von Vorteil sind die Maßnahmen, bei denen die relevanten Dimensionen der Verarbeitungsmaschine und weiterer Komponenten, insbesondere Greifer für die Manipulation der Spritzgießteile, Förderbänder, Automatisierungsanlagen, Mühlen, Schutzeinhausungen, etc., die zusammen mit dem physikalischen Roboter eine Arbeitszelle bilden und für die Interaktion mit dem Roboter wesentlich sind, entweder digital an die Robotsteuerung übermittelt bzw. abgefragt oder mit Hilfe von Messeinrichtungen ermittelt werden, und von der Robotsteuerung in die Validierung zur Erkennung von möglichen Kollisionszuständen aufgenommen werden. Dadurch wird einerseits erreicht, dass in der Robotsteuerung sämtliche Daten der Dimensionen, insbesondere der Störkonturen, übermittelt bzw. vorhanden sind, die von der Robotsteuerung in der virtuellen Darstellung des Roboters einbezogen werden, sodass der Maschineneinsteller sofort visuell erkennen kann, wo Probleme, insbesondere Kollisionen, entstehen können. Je nach Vorhandensein und Güte der übermittelten Konturdaten der externen Komponenten der Arbeitszelle kann die Robotsteuerung auch selbständig auf potentielle Kollisionspunkte hinweisen. Andererseits ist es auch möglich, dass externe Komponenten in der Arbeitszelle keine Kontur- und Positionsdaten an den physikalischen Roboter übermitteln, da sie über keine entsprechende Schnittstelle bzw. Kenntnis der eigenen Daten verfügen. Optional kann der physikalische Roboter mit entsprechenden Messeinrichtungen ausgestattet sein, die die Objekte im Arbeitsbereich des Roboters entweder in einem Lernmodus ermitteln oder kontinuierlich im Betrieb erlernen und sich der Roboter somit über Zeit ein kompletteres Abbild der Arbeitszelle aufbaut. Jedoch muss erwähnt werden, dass das erfindungsgemäße Verfahren auch ohne Kenntnis der Arbeitsumgebung des Roboters angewendet werden kann und zur Steigerung der Betriebssicherheit beiträgt und somit das gewünschte Resultat bringt.

Vorteilhaft sind die Maßnahmen, bei denen programmierte oder ermittelte Bewegungsräume des physikalischen Roboters im virtuellen Robotmodell räumlich und farblich dargestellt werden, um erlaubte Verfahr- und Bewegungsbereiche für den Bediener erkennbar zu machen.

Es sind die Maßnahmen von Vorteil, bei der der Bediener beim virtuellen Robotmodell die Möglichkeit hat, durch manuelle Veränderung von peripheren Zuständen, die Abfolge der Bewegungs- und Funktionssequenzen zu beeinflussen und somit Abläufe zu testen, die mit dem physikalischen Roboter nur schwer zu simulieren wären. Dadurch können auch Programmsequenzen virtuell auf Richtigkeit überprüft werden, die nur in Ausnahmefällen zur Ausführung kommen würden. Ebenso kann die Logik der Verknüpfung von Bedingungen zur Weiterführung in der Ablaufsequenz überprüft werden.

Auch sind Maßnahmen vorteilhaft, bei denen das virtuelle Robotmodell das Teachprogramm in beschleunigter Zeit, also in Zeitraffer, abarbeitet. Typischer Weise macht der Roboter in einem Produktionszyklus die im wesentlichen gleichen Bewegungen. Beispielsweise führt das Abstapeln von Teilen in eine Kiste aber zu jeweils leicht unterschiedlichen Bewegungen, da der Füllstand der Kiste mit jedem Produktionszyklus erhöht wird. Durch die Möglichkeit, den Gesamtproduktionszyklus für das Befüllen einer ganzen Kiste auf dem virtuellen Robotmodell in Zeitraffer ablaufen zu lassen, können auch Problemsituationen, die nicht bereits im ersten Zyklus auftreten, binnen kürzester Zeit erkannt werden. Speziell beim Abstapeln von Spritzgießteilen ergibt sich die Situation, dass am Beginn, also bei leerer Kiste, der Roboter einen längeren Verfahrweg benötigt, als bei fast voller Kiste. Die problematische Situation mit den dann gegebenen Zuständen des Roboters werden dem Bediener dann auf dem virtuellen Modell verdeutlicht.

Es sind Maßnahmen von Vorteil, bei denen das virtuelle Robotmodell derart betrieben wird, dass alle oder einige der möglichen Verzweigungen, die eine Teachprogrammabarbeitung nehmen kann, automatisiert erfasst werden und vom virtuellen Robotmodell ohne weitere Benutzerinteraktion, in Zeitraffer durchgetestet werden. Wird eine potentielle Kollision im Pfad des Roboters erkannt, dann wird dem Benutzer die Situation auf dem virtuellen Robotmodell auf der Robotsteuerung verdeutlicht und auf die Teachbefehlszeile, die die Kollision verursacht hingewiesen.

Auch sind Maßnahmen von Vorteil, bei denen die Möglichkeit das virtuelle Robotermodell in Zeitraffer ablaufen zu lassen, dahingehend genutzt wird, die zu erwartende Zykluszeit, d.h. die Zeit wie lange die Entnahme und Ablage des produzierten Teils bis zur Rückkehr des Roboters zur Entnahmeposition über der Spritzgießmaschine, sofort oder auch bereits während des Teach-in-Vorgangs laufend aktualisiert abzuschätzen. Oft ist die zu erreichende Zykluszeit bereits im Vorfeld bekannt. Durch die schnelle Abschätzung durch Verwendung des virtuellen Robotmodells in Zeitraffer kann der Teach-in Prozess auf Erreichen oder Unterschreiten dieser Zeit hin optimiert werden, wobei die Zeit, die vom Bediener hierfür benötigt wird durch die Zeitraffer deutlich verkürzt wird.

Vorteilhaft sind auch Maßnahmen, die das virtuelle Robotmodell bereits mit der im späteren Betrieb vorgesehenen Geschwindigkeit testen, das sind typischerweise 100% der konstruktiv möglichen Geschwindigkeit. Im Gegensatz für z.B. Schweißroboter kommt es bei der Entnahme von Kunststoffteilen im Allgemeinen nicht auf eine exakt geschwindigkeitsunabhängige Bahntreue des Entnahmeroboters an. Viel mehr ist die schnelle dynamische Änderbarkeit, d.h. Neuberechnung, der Bahn bei plötzlichen Ereignissen (z.B. Teileverlust, Aktivschaltung eines Gefahrenbereichs) unter Einhaltung von Belastungsgrenzen der Mechanik von Bedeutung. Das kann durch ein Tiefpassfilter, mit der die errechnete Bahn vor Beschickung an die Antriebsregler, beaufschlagt wird, erreicht werden. Diese Filterung bedingt aber auch, dass die tatsächliche Bahn von der errechneten beispielweise beim Verschleifen von Bewegungen geringfügig abweicht (abkürzt). Im Extremfall kann dadurch ein üblicherweise als Quader definierter Gefahrenbereich verletzt werden. Diese Situation kann durch das virtuelle Robotmodell im Vorhinein simuliert werden, auf Wunsch auch in Zeitraffer. Etwaige Verletzungen können dann auf dem virtuellen Robotermodell dem Benutzer erläutert werden.

In ähnlicher Weise sind Maßnahmen von Vorteil, wo Teachprogramme, die nicht geschwindigkeitsunabhängig geteacht wurden, sondern bewusst oder unbewusst einer Zeitsteuerung unterliegen, mit dem virtuellen Robotmodell durchsimuliert werden können. Etwaige Problemsituationen können dann entweder optisch durch den Benutzer durch Beobachtung des auf der Robotsteuerung visualisierten dreidimensionalen Modells oder durch die Erfassung von Kollisionssituationen erkannt werden.

Wie zuvor beschrieben, kann das virtuelle Robotmodell in den unterschiedlichsten Betriebsarten simuliert betrieben werden. Die Auswahl der Betriebsarten kann über die Robotsteuerung, insbesondere den Bildschirmtasten und/oder Touch-Screen, ausgewählt und eingestellt werden. Dabei kann durch Aktivieren der Zeitraffer-Funktion mehrere, insbesondere eine Vielzahl von Produktionszyklen in kurzer Zeit überprüft werden.

Die Maßnahmen sind vorteilhaft, bei denen der virtuelle Roboter Teil einer virtuellen Arbeitszelle ist und weitere Geräte der Arbeitszelle wie Spritzgießmaschine, Entnahmegreifer, Angusszange, Förderband und sonstige Peripherie- und Automatisierungskomponenten im Kontext des virtuellen Roboters dargestellt werden und optional in der Validierung berücksichtigt werden können. Dadurch wird erreicht, dass auf der Robotsteuerung sämtliche Komponenten dargestellt sind, deren Funktionen, Abmessungen bzw. Dimensionen in der Programmerstellung bzw. Ablaufsequenz von Bedeutung sein könnten und somit dem Bediener ein kompletteres Abbild der physikalischen Arbeitszelle vermitteln. Das dient wesentlich zur Vereinfachung der Bedienung und zur besseren bildlichen Darstellung einer Zelle.

Von Vorteil sind die Maßnahmen, bei denen in die Visualisierung der Arbeitszelle gezoomt werden kann, wobei die Perspektive frei wählbar und jederzeit verändert werden kann. Dadurch wird erreicht, dass immer die optimale Sicht auf ev. Problemstellen hergestellt werden kann, wogegen der Maschineneinsteller bei der physikalischen Anlage oftmals nicht jede beliebige Sicht einnehmen kann. Insbesondere das Hineinzoomen in Räume, in die der Maschineneinsteller eigentlich keine Sicht hat, hat sich als sehr vorteilhaft herausgestellt, da bei Auftreten von Fehlern in diesen Bereichen das Auffinden auf physikalischen Anlagen sehr schwer und langwierig ist.

Einen zusätzlichen Vorteil bietet die Möglichkeit, das Teachprogramm auf einem externen Rechner zu erstellen oder von der Robotsteuerung dorthin zu übertragen. Ebenso kann die Konfigurationsdatei mit den wesentlichen Einstellungen des physikalischen Roboters auf den externen Rechner übermittelt werden und somit eine Offline-Überprüfung der Ablaufsequenz möglich ist. Dadurch wird erreicht, dass auch Offline abseits der Anlage eine Überprüfung bzw. Analyse durchgeführt werden kann.

Weiters wird die Aufgabe der Erfindung durch eine Robotsteuerung gelöst, bei derVerfahrensparameter, Ausstattungsmerkmale und Funktionalitäten des physikalischen Roboters in einer Konfigurationsdatei gespeichert sind, wobei die Robotsteuerung zum Erstellen eines virtuellen Robotmodells auf diese Konfigurationsdatei und zur Validierung einer Ablaufsequenz auf das aktuelle Teachprogramm in der Robotsteuerung zugreift, wobei die Visualisierung der Ablaufsequenz direkt auf der Robotsteuerung anzeigbar ist, wobei die Robotersteuerung zum Erstellen eines virtuellen Robotmodells aus dieser Konfigurationsdatei und zur Validierung einer Ablaufsequenz auf das aktuelle Teachprogramm in der Robotsteuerung ausgebildet ist, wobei die Visualisierung der Ablaufsequenz direkt auf der Robotsteuerung anzeigbar ist, wobei der virtuelle Roboter nach der Entkopplung und Validierung bestimmter Befehle und Teilsequenzen im Teachprogramm jederzeit mit dem physikalischen Roboter koppelbar und in den Ausgangszustand zurücksetzbar ist, um anschließend weitere Teilsequenzen des Teachprogramms im gekoppelten oder entkoppelten Zustand zu validieren.

Vorteilhaft ist hierbei, dass die Bedienerfreundlichkeit wesentlich erhöht wird, da direkt an der Anlage über die Robotsteuerung sämtliche Abläufe über das virtuelle Robotmodell möglich sind. Dadurch können die Verfahrwege des Roboters kontrolliert und überprüft werden und im virtuellen Robotmodell ev. Problemstellen erkannt bzw. aufgefunden werden. Dabei ist es auch möglich, dass eine virtuelle Kollision des Roboters mit einer anderen Komponente automatisch erkannt wird und dies angezeigt wird bzw. ein Warnsignal ausgesendet wird.

Grundsätzlich kann gesagt werden, dass durch die erfindungsgemäße Lösung sichergestellt werden kann, dass vor Start des Automatikbetriebes des Roboters eine umfangreiche Überprüfung sämtlicher Möglichkeiten der Ablaufsequenz durchgeführt werden kann und somit sämtliche potentiellen Fehlerquellen auf einfache Art und Weise erkannt und behoben werden können.

Die Erfindung wird an Hand mehrerer in den Zeichnungen dargestellter Ausführungsbeispiele näher erläutert.

Es zeigen:
- Fig. 1: ein Übersichtbild einer kunststoffverarbeitenden Industrieanlage, in vereinfachter, schematischer Darstellung;
- Fig. 2: eine schematische Darstellung einer Teachbox als Teil einer Robotsteuerung-für die Programmerstellung in vereinfachter, schematischer Darstellung
- Fig. 3: eine schematische Darstellung eines virtuellen Robotmodells auf einer Robotsteuerung, in vereinfachter, schematischer Darstellung;
- Fig. 4: eine schematische Darstellung des Robotmodells in vergrößerter Perspektive und geänderter Position des Roboters, bei der die Entnahmevorrichtung in die geöffnete Werkzeugform zum Entnehmen des hergestellten Spritzgießteils eingefahren ist.

Einführend sei festgehalten, dass in den unterschiedlichen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die neue Lage zu übertragen. Auch können Einzelmerkmale oder Merkmalskombinationen aus den gezeigten und beschriebenen Ausführungsbeispielen für sich eigenständige erfinderische Lösungen darstellen.

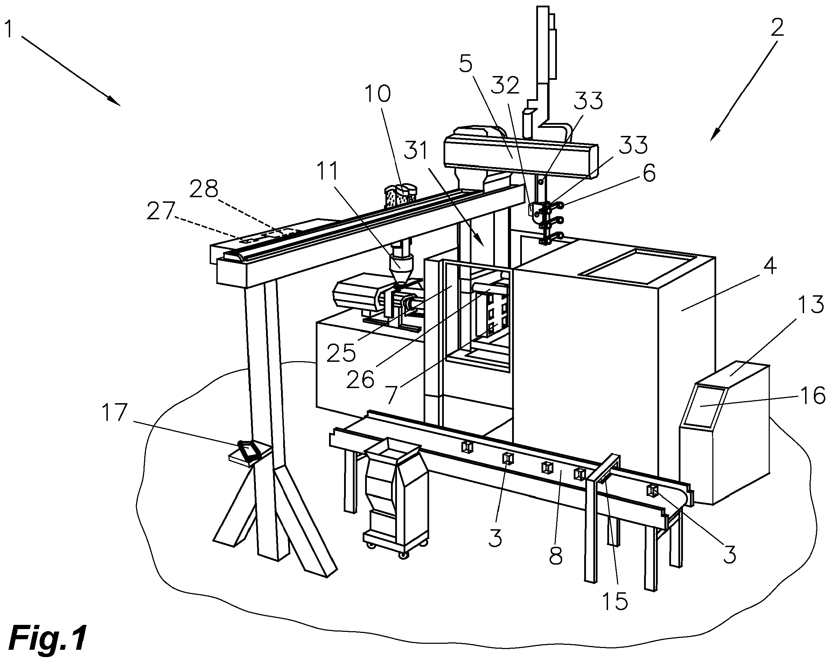

In Fig. 1 ist eine Industrieanlage 1, insbesondere eine Arbeitszelle 2 für Spritzgießanwendungen gezeigt, bei der die einzelnen Komponenten/Geräte zum Erzeugen eines oder mehrerer Produkte/Halbprodukte oder Spritzgießteile 3 in der Arbeitszelle 2 zusammen geschaltet sind. Als Verarbeitungsmaschine wird vorzugsweise eine Spritzgießmaschine 4, eingesetzt, der ein Roboter 5 bzw. Handhabungsautomat zum Entnehmen des hergestellten Spritzgießteils 3 zugeordnet ist, wobei das Spritzgießteil 3 von einer Entnahmevorrichtung 6, insbesondere einem Greifer ausgestattet mit Greifzangen oder Saugdüsen, aus einer sich öffnenden Spritzgussform 7 entnommen und auf eine Vorrichtung, insbesondere einem Transportband 8, abgelegt wird. Um ein Spritzgießteil 3 herstellen zu können, wird Kunststoffgranulat 9 über ein Granulatfördergerät 10 und eventuell über ein Dosiergerät 11 der Verarbeitungsmaschine 4 zugeführt. Über ein Temperiergerät 13 und/oder Kühlgerät kann die Spritzgussform durch Zuführung eines Temperiermediums auf Betriebstemperatur gehalten werden bzw. entsprechend geheizt oder gekühlt werden, sodass eine optimale Verarbeitung des Kunststoffgranulates 9, welches zum Einspritzen in die Spritzgussform 7 plastifiziert werden muss, ermöglicht wird. Zusätzlich weist die Anlage eine Überwachungsvorrichtung 15, insbesondere ein Kamerasystem, auf, um eine automatische Qualitätskontrolle des erzeugten Produktes 3 durchführen zu können. Damit die einzelnen Geräte eingestellt bzw. programmiert werden können, weisen diese entsprechende Steuerelektronik auf, die über an den Geräten angeordneten Displays 16 oder einer Robotsteuerung 17 eingegeben und angezeigt werden. Der vollständigkeitshalber wird weiters erwähnt, dass sämtliche Geräte mit entsprechenden Leitungen, insbesondere Spannungsversorgung, Netzwerkleitungen, Flüssigkeitsversorgungsleitungen, Materialleitungen usw. verbunden sind, die in der gezeigten Darstellung der übersichtshalber nicht dargestellt wurden.

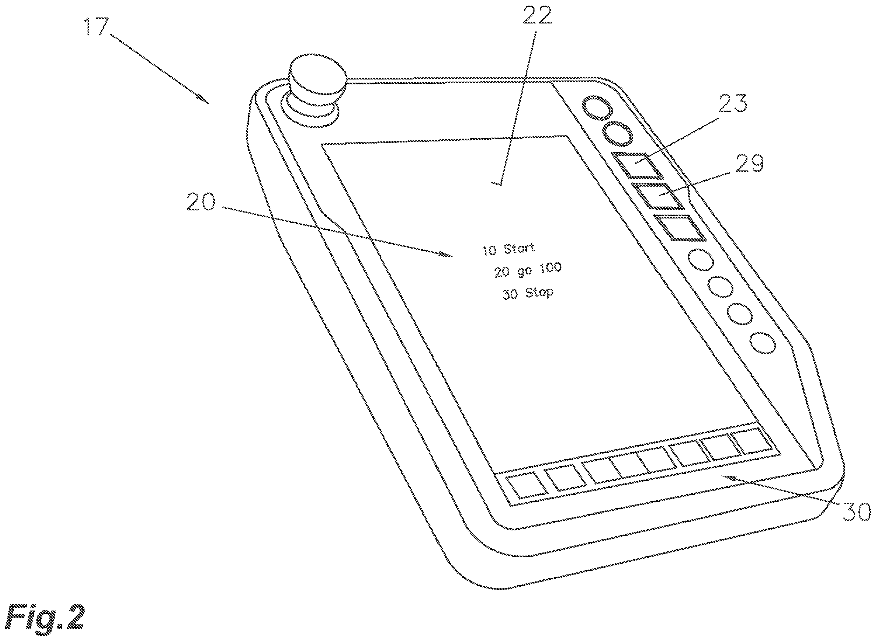

Gemäß der Fig. 2 bis 4 ist erfindungsgemäß ein Verfahren und ein Roboter 5 und/oder Robotsteuerung 17 beschrieben, bei dem eine Validierung von programmierten Ablaufsequenzen oder Teachprogrammen 20 des Roboters 5 bzw. Handhabungsautomaten vorzugsweise mit der Robotsteuerung 17 durchführbar ist. Dabei ist der Roboter 5 vorzugsweise auf oder neben der Verarbeitungsmaschine, insbesondere der Spritzgießmaschine 4, montiert und dient für die Entnahme, Handhabung, Manipulation oder Weiterbearbeitung von gerade produzierten Spritzgießteilen 3.

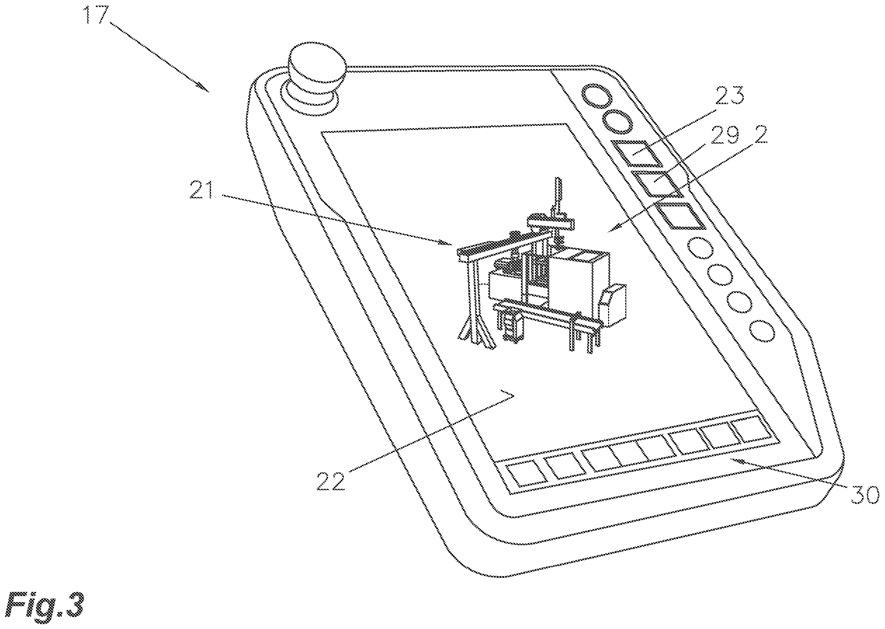

Die Robotsteuerung 17 ist zur Wiedergabe eines virtuellen Zwillings bzw. virtuellen Robotmodells 21 (gemäß Fig. 3), insbesondere einer virtuellen Darstellung der Anlage bzw. Arbeitszelle, am Ausgabepunkt, insbesondere einem Touch-Screen 22, ausgebildet, wobei vorzugsweise sämtliche Produktionsmittel der Anlage bzw. Arbeitszelle 2 dargestellt sind. Die Erstellung der virtuellen Gesamtansicht kann vorzugsweise automatisch erfolgen, wobei die benötigten Daten von der Robotsteuerung 17 aus den einzelnen Komponenten ausgelesen werden. Das virtuelle Robotmodell 21, der sogenannte "digitale Zwilling" wird in jedem Fall automatisch aus der Konfigurationsdatei 27 der Robotsteuerung 17 erstellt. Hierbei ist es auch möglich, dass aufgrund von gespeicherten und ausgelesenen Kennungen bzw. Typenbezeichnungen der Geräte im Speicher der Robotsteuerung 17 entsprechende virtuelle Modelle, insbesondere deren Form und Dimensionen, hinterlegt sind oder dass in dem einzelnen erfassten Produktionsmittel Daten für den Aufbau, insbesondere der Anordnung, der Lage und der Funktion, sowie eine digitale Darstellung des Produktionsmittel gespeichert sind, die von der Robotsteuerung 17 und/oder dem Roboter 5 über ein Verarbeitungsnetzwerk abfragbar sind.

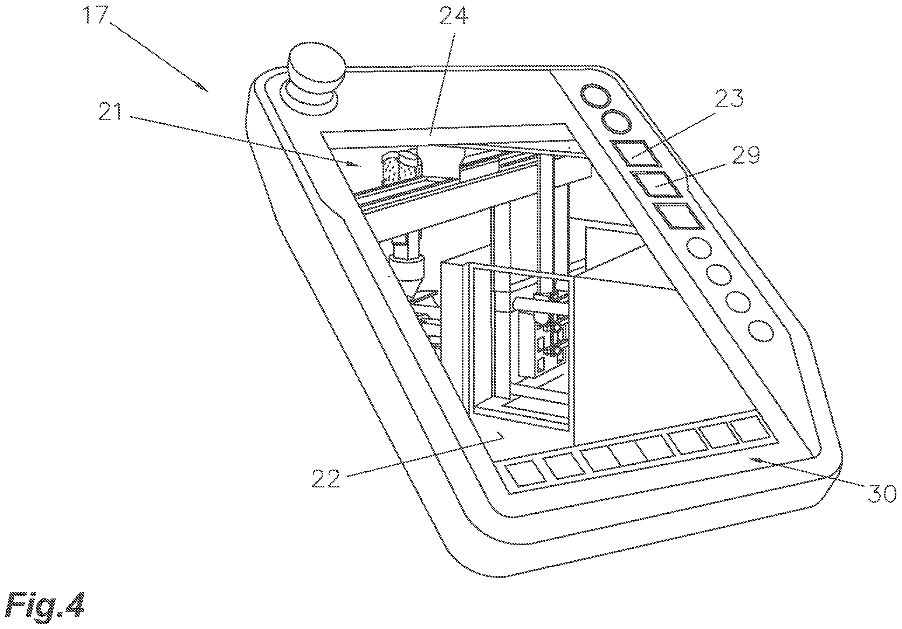

Die Robotsteuerung 17 ist dabei mit den neuesten Hardware- und Software-Technologien im Hinblick auf erhöhte Leistungsfähigkeit und Betriebssicherheit ausgestattet. Dadurch ist es möglich, dass auf der Robotsteuerung 17, standardmäßig ein digitaler Robot-Zwilling, also das virtuelle Robotmodell 21, zur Verfügung steht, der die Validierung der vom echten Roboter 5 auszuführenden Abläufe jederzeit virtuell ermöglicht und somit ohne Gefahr für Verarbeitungsmaschine und Roboter 5 die Abläufe vor der Inbetriebnahme überprüft werden können, wie dies anhand der Darstellungen von Fig. 3 und Fig. 4 zu ersehen ist, indem die Entnahmevorrichtung 6 des Roboters 5 von der Position oberhalb der Spritzgussform 7 der Spritzgießmaschine 4, gemäß Fig. 3 in die geöffnete Spritzgussform 7 der Spritzgießmaschine 4 eingefahren ist, gemäß Fig. 4.

Wesentlich ist hierbei, dass die Robotsteuerung 17 die tatsächlichen Vorgaben des gespeicherten Teachprogrammes 20 dem virtuellen Robotmodell 21 zur Verfügung stellt, sodass am virtuellen Robotmodell 21 der tatsächliche Ablauf dargestellt wird.

Die Robotsteuerung bietet einen Darstellungsbereich, beispielsweise von 10,1" im Porträtformat und verfügt über eine, dem aktuellen Tablet-Trend folgende kapazitive Touch-Oberfläche des Touch Screens 21. Dieser ermöglicht nun auch die Gestensteuerung, insbesondere das Wischen für Seitenwechsel und Zoomen mit zwei Fingern (wie dies in Fig. 4 geschehen ist), was die Bedienung der Robotsteuerung 17 noch intuitiver gestaltet. Vorzugsweise weist die Robotsteuerung 17 mehrere Mehrkern-Prozessoren, die eine optimale Aufgabenteilung ermöglichen und so die Leistungsfähigkeit verbessern, auf. Zeit- bzw. sicherheitsrelevante Prozesse können komplett von der Visualisierungsebene entkoppelt werden, um höchste Betriebssicherheit und die schnellstmögliche Reaktion auf kritische Ereignisse zu realisieren.

Basierend auf der Programmierung, also dem hinterlegten Teachprogramm 20, generiert die Robotsteuerung 17 eine virtuelle Arbeitszelle bzw. das Robotmodell 21, in deren Visualisierung gezoomt werden kann, wobei die Perspektive frei wählbar und jederzeit änderbar ist, d.h., dass bei einer Simulation also eines virtuellen Ablaufes der Maschineneinstellung jederzeit die Ansicht auf das dargestellte Robotmodell 21 verändern kann, um Bereich zu kontrollieren, die so nicht sichtbar sind. Auch kann in das dargestellte Modell hineingezoomt werden, sodass nur noch ein Teil des virtuellen Robotmodells 17 sichtbar ist, jedoch die Simulation weiter fortgeführt wird, sodass beim Verkleinern wieder alle Abläufe sichtbar werden.

Man kann also sagen, dass eine digitale Kopie, also ein digitaler Zwilling oder virtuelles Robotmodell 21, der tatsächlichen Arbeitszelle 2 bzw. des Roboters 5 in der Robotsteuerung 17 mitgeführt wird bzw. simuliert ist bzw. die Robotsteuerung 17 entsprechend zur Anzeige des virtuellen Robotmodells 21 ausgebildet ist. Dieses virtuelle Robotmodell 21 verfügt über dieselben Ausstattungsmerkmale und Charakteristika wie der real existierende Roboter 5, und erlaubt somit eine realitätsnahe Simulation der anwendungsspezifischen Abläufe.

Dabei ist es jederzeit möglich, dass Abläufe bei der Programmierung eines Teachprogramms 20 überprüft werden können , d.h., dass sobald entsprechende Teile eines Robotprogramms bzw. Teachprogramms 20 erstellt wurden, die Möglichkeit besteht, über das Test-Menü der Robotsteuerung 17, welches beispielsweise durch Aktivieren eines Button 23 aufrufbar ist, in den Simulationsmodus zu wechseln und die gerade eben erstellte Teilsequenz zu überprüfen. Um nun das virtuelle Robotmodell 21 am Touch-Screen eindeutig vom realen Equipment, also den physikalischen Roboter, zu unterscheiden, erscheint in diesem Modus vorzugsweise eine leuchtende Statuszeile 24 auf dem Bildschirm der Robotsteuerung 17, und zusätzlich erfährt der virtuelle Roboter eine schemenhafte Darstellung.

Der Simulationsmodus erlaubt auch die Simulation der Spritzgießmaschine 4 anhand von hinterlegten Kenngrößen, die von der Robotsteuerung 17 abgefragt und beispielsweise aus einem Speicher in der Spritzgießmaschine 4 ausgelesen wird. Selbstverständlich ist es möglich, dass auch weitere Komponenten simuliert bzw. deren Daten ausgelesen und virtuell umgesetzt werden können.

Der Simulationsmodus versetzt den Bediener bzw. Maschineneinsteller somit in die Lage, gegebenenfalls folgenschwere Fehler im Robotprogramm 20 sehr rasch aufzudecken, ohne bei einem real durchgeführten Testlauf ein Risiko eingehen zu müssen. Bewegungsabläufe von hoher Komplexität, die sich aus bis zu sechs gleichzeitigen Bewegungen zusammensetzen, wie etwa den Bewegungen sämtlicher Roboterachsen und zusätzlich weiterer Achsen, etwa von Drehachsen , und die zu einer Kollision des Roboters 5 mit der Schutzeinhausung 25 oder den Holmen 26 der Spritzgießmaschine 4 führen könnten, können somit einfach überprüft werden, sodass diese ihren programmiertechnischen "Schrecken" verlieren. So lassen sich bei der Simulation auch Fehler in der Ablauflogik entdecken, sowie potenzielle Synchronisierungsprobleme bei überlagerten und simultan laufenden Funktionen.

Das virtuelle Robotmodell 21 steht in jedem Betriebsmodus für den gesamten Ablauf zur Verfügung, also auch im so genannten "Trockenbetrieb" und im Hand- bzw. Stepp-Betrieb. Es ist auch möglich, dass die Robotsteuerung 17 im Handbetrieb und während eines Trockenlaufzyklus ihre Antikollisions-Kontrolle aktiviert. Diese meldet permanent die Stromaufnahme jedes einzelnen Antriebs. Bei zu großen Abweichungen vom Standardwert und somit einer höchstwahrscheinlichen Kollision des Roboters 5 mit anderen Komponenten in der Arbeitszelle 2, erfolgt eine sofortige Abschaltung der Antriebe. Dadurch sind die tatsächlichen Istwerte am virtuellen Robotmodell 21 zu den entsprechenden Teilen darstellbar bzw. werden angezeigt, d.h., dass beispielsweise bei einer kritischen Stromaufnahme eines Antriebes dieser im virtuellen Robotmodell 21 rot eingefärbt wird, sodass vom Bediener bzw. Maschineneinsteller erkennbar ist, wo die Grenzwerte überschritten oder problematisch sind. Dabei ist es möglich, dass entsprechende Bereiche für die Parameterwerte hinterlegt und gespeichert werden bzw. sind, sodass die entsprechenden Teile mit entsprechend dazugehörigen Farben eingefärbt werden, was die Bedienerfreundlichkeit wesentlich erhöht, d.h., dass bei Überschreiten definierter Grenzwerte, also den einstellbaren Parametern, die entsprechenden Komponenten mit Farbe, insbesondere mit Rot, im virtuellen Robotmodell 21 dargestellt sind oder eben nur die Werte angezeigt werden.

Als vorteilhafte und betriebssichere Ausbildung hat sich gezeigt, dass im Roboter 5 spezielle Daten in einer Konfigurationsdatei 27, wie schematisch mit strichlierten Linien dargestellt, gespeichert sind, wobei die Konfigurationsdatei 27 die Verfahrparameter, Ausstattungsmerkmale und Funktionalitäten des physikalischen Roboters 5 enthalten. Dabei greift der Roboter 5 steuerungsseitig auf die Konfigurationsdatei 27, insbesondere die darin gespeicherten Daten, zu, sodass beispielsweise die Beschleunigungsrampen der einzelnen Achsen vom Roboter 5 aus der Datei ausgelesen werden und somit im Betrieb als Sollwerte herangezogen werden. Auch die weiteren enthaltenen Parameter werden für den Betrieb des Roboters 5 herangezogen, wobei auch zusätzliche Daten von der Robotsteuerung 17 für den Betrieb verwendet werden können.

In gleicher Weise greift die Robotsteuerung 17 für die Ausbildung des virtuellen Robotmodells auf die Konfigurationsdatei 27 zu und liest die Daten aus. Zur Validierung einer Ablaufsequenz für den virtuellen Roboter bzw. das Robotmodell 21 greift die Robotsteuerung 17 auf das aktuelle in ihr gespeicherte Teachprogramm 20 zurück, wobei die Visualisierung der Ablaufsequenz direkt auf der Robotsteuerung 17 angezeigt wird. Damit dies möglich ist, ist eine entsprechende Software auf der Robotsteuerung 17 ausgebildet, mit der einerseits auf die Konfigurationsdatei 27 und auf das hinterlegte Teachprogramm 20 zugegriffen wird, um die Daten miteinander zu kombinieren und daraus ein funktionstüchtiges virtuelles Robotmodell 21 für Simulationsabläufe auf der Robotsteuerung 17 zu erschaffen.

Dabei kann das virtuelle Modell 21 in jeder Betriebsart des Roboters 5 an der Robotsteuerung 17 simuliert werden. Hierbei ist es möglich, dass über einen Umschaltbutton 29 zwischen dem Teachprogramm 20 und dem virtuellen Robotmodell 21 einfach hin und her gesprungen werden kann, sodass am Teachprogramm 20 gearbeitet werden kann und sofort die erstellten Abschnitte durch einfaches Umschalten auf dem virtuellen Robotmodell 21 ausgetestet werden können. Dabei ist es auch möglich, dass im Stepp-Betrieb das virtuelle Robotmodell 21 vom Roboter 5 entkoppelt wird und über die entsprechenden Tasten 30 das Teachprogramm 20 nur vom virtuellen Roboter abgesteppt wird. Anschließend kann das virtuelle Robotmodell 21 und der physikalische Roboter 5 wieder gekoppelt werden, sodass das virtuelle Robotmodell 21 dem Roboter 5 folgt und für eine neuerliche Aufnahme einer virtuellen Validierung der nachfolgenden Befehle im Teachprogramm 20, der virtuelle Roboter in der richtigen Ausgangsposition beginnt. Vorteilhaft ist hierbei, dass der User jederzeit die Perspektive verändern kann und auch das Robotmodell 21 einfach vergrößern kann, um einen möglichst genauen und optimalen Verfahrweg aufzunehmen. Auch können hierbei nur Teilsequenzen erstellt werden, die im gekoppelten Zustand überprüft werden.

Um eine optimale und einfache Kontrolle für den Bediener bzw. Maschineneinrichter zu ermöglichen, können die möglichen Bewegungsräume 31 farblich gekennzeichnet sein, sodass sofort erkennbar ist, wo der Roboter 5, insbesondere die Entnahmevorrichtung 6 ohne Kollision bewegt werden kann. Überschreitet die Entnahmevorrichtung 6 beispielsweise einen derartig gekennzeichneten Bewegungsraum 31 so wird von der Robotsteuerung 17 ein Stopp aller Achsbewegungen durchgeführt und optional ein entsprechendes Warnsignal, beispielsweise ein Piep-Ton oder eine blinkende Anzeige des Modells, ausgegeben.

Es ist auch möglich, dass in der Robotsteuerung 17 virtuelle Modelle der unterschiedlichsten Komponenten des Herstellers und auch fremder Produkte gespeichert sind, die einer entsprechenden Kennung bzw. Typenbezeichnung zugeordnet sind. Diese Kennung bzw. Typenbezeichnung sind in den einzelnen Komponenten gespeichert, sodass diese von der Robotsteuerung 17 abgefragt und anschließend das entsprechende virtuelle Modell generiert wird. Dabei ist es auch möglich, dass bei neuen Geräten die virtuellen Modelle in einer Datei gespeichert sind, die von der Robotsteuerung 17 ausgelesen und in ihrer Datenbank speichern kann, sodass diese für zukünftige Anwendung zur Verfügung stehen. Auch ist es möglich, dass die virtuellen Modelle in einer externen Datenbank gespeichert sind und die Robotsteuerung 17, wenn benötigt, diese in ihren Speicher laden kann. Grundsätzlich ist es möglich, dass der Bediener bzw. der Maschineneinsteller die virtuellen Modelle frei positionieren kann, wobei vorzugsweise jedoch entsprechende Daten für die Position über einen Messzyklus erfasst oder hinterlegten Daten der Position vorhanden sind.

Zum Festlegen der Positionen der Störkonturen bzw. der Positionen der einzelnen Geräte kann der Roboter 5 mit einer Messvorrichtung 32, die mehrere Sensoren 33 zur Ermittlung des Abstandes, wie schematisch dargestellt, aufweist, ausgestattet sein, sodass durch langsames Abfahren in allen Raumrichtungen die Positionen der Geräte und/oder Bewegungsräume 31 ermittelt und gespeichert werden. Diese Daten werden anschließend in das virtuelle Robotmodell 21 integriert und es können ev. Korrekturen beim bestehenden Robotmodell 21 durchgeführt werden.

Weiters hat der Bediener beim virtuellen Robotmodell 21 auf der Robotsteuerung 17 die Möglichkeit, durch manuelle Veränderung von peripheren Zuständen, die Abfolge der Bewegungs- und Funktionssequenzen zu beeinflussen und somit Abläufe zu testen, die mit dem physikalischen Roboter 5 nur schwer zu simulieren wären, d.h., dass sich damit Abläufe testen lassen, die beim tatsächlichen Roboter 5 nur in den seltensten Fällen und somit schwer nachvollziehbar, auftreten.. Dies kann ohne Abschalten und Unterbrechung der Anlage auf der Robotsteuerung 17 simuliert werden.

Es ist auch möglich, dass das virtuelle Robotmodell 21 derart eingestellt bzw. gestartet wird, dass das Teachprogramm 20 oder Teile daraus in beschleunigter Zeit, insbesondere in Zeitraffer, betrieben wird. Somit kann in kurzer Zeit eine Vielzahl von Produktionszyklen durchlaufen werden. Auch ist es möglich, dass die Anzahl der durchzulaufenden Produktionszyklen frei einstellbar sind. Vorzugsweise kann der User bzw. Maschineneinsteller aus unterschiedlich definierten Geschwindigkeiten, wie beispielsweise, 2x, 4x, 8x, oder 16x, für die Zeitraffer-Funktion auswählen. Der Vollständigkeitshalber wird erwähnt, dass selbstverständlich auch ein langsamer Ablauf, wie beispielsweise 0,7x, 0,5x oder 0,3x, möglich ist oder die Geschwindigkeit für die Zeitraffer-Funktion frei einstellbar ist.

Auch ist es möglich, dass das virtuelle Robotmodell (21) derart betrieben wird, dass alle oder einige der möglichen Verzweigungen, die eine Teachprogrammabarbeitung nehmen kann, automatisiert erfasst und durchgetestet werden. Damit können automatisch sämtlich eintretende Möglichkeiten vollständig überprüft werden.

Der Ordnung halber wird darauf hingewiesen, dass die Erfindung nicht auf die dargestellten Ausführungsvarianten beschränkt ist, sondern auch weitere Ausbildungen beinhalten können.

## Patentansprüche

1. Verfahren zur Validierung von programmierten Ablaufsequenzen oder Teachprogrammen (20) eines Roboters (5) mit einer Robotersteuerung (17), wobei der Roboter (5) auf oder neben einer Spritzgießmaschine (4), montiert wird und für die Entnahme, Handhabung, Manipulation oder Weiterbearbeitung von gerade produzierten Spritzgießteilen (3) dient, wobei Verfahrparametern, Ausstattungsmerkmale und Funktionalitäten des physikalischen Roboters (5) steuerungsseitig in einer Konfigurationsdatei (27) gespeichert werden und die Robotersteuerung (17) aus diesen hinterlegten Daten ein virtuelles Robotmodell (21) erstellt und zur Validierung einer Ablaufsequenz auf das aktuelle Teachprogramm (20) in der Robotsteuerung (17) zurückgreift, wobei die Visualisierung der Ablaufsequenz direkt auf einer Ausgabeeinheit der Robotsteuerung (17) angezeigt wird, wobei das virtuelle Robotmodell (21) in jeder beliebigen Befehlszeile des Teachprogramms (20) vom physikalischen Roboter (5) entkoppelt wird und für die Validierung bestimmter Befehle und Teilsequenzen im Teachprogramm (20) auf potenzielle Kollisionen oder Fehlverhalten verwendet wird, wobei der virtuelle Roboter im gekoppelten Zustand dem physikalischen Roboter (5) folgt und bei Entkopplung diese Synchronisation zwischen virtuellem und physikalischem Roboter (5) gestoppt wird, wobei der gekoppelte physikalische Roboter (5) den aktuellen Programmablauf bis zu einer möglichen Kollisionssituation ausführt und erst dann auf das virtuelle Robotmodell (21) mit Nachstellung von gefährlichen Zuständen umgeschaltet wird, wobei der virtuelle Roboter (5) nach der Entkopplung jederzeit wieder mit dem physikalischen Roboter (5) gekoppelt und in den Ausgangszustand zurückgesetzt wird, um anschließend weitere Teilsequenzen des Teachprogramms (20) zu validieren.

2. Verfahren nach Anspruch 1, **dadurch gekennzeichnet, dass** die relevanten Dimensionen der Verarbeitungsmaschine und weiterer Komponenten, insbesondere Greifer (6) für die Manipulation der Spritzgießteile (3), Förderbänder (8), Automatisierungsanlagen, Mühlen, Schutzeinhausungen (25), etc., die zusammen mit dem physikalischen Roboter (5) eine Arbeitszelle (2) bilden und für die Interaktion mit dem Roboter (5) ausgebildet sind, entweder digital an die Robotsteuerung (17) übermittelt bzw. abgefragt oder mit Hilfe von Messeinrichtungen (32) ermittelt werden, und von der Robotersteuerung (17) in die Validierung zur Erkennung von möglichen Kollisionszuständen aufgenommen werden.

3. Verfahren nach einem der vorhergehenden Ansprüche, **dadurch gekennzeichnet, dass** programmierte oder ermittelte Bewegungsräume (31) des physikalischen Roboters (5) im virtuellen Robotmodell (21) räumlich und farblich dargestellt werden, um erlaubte Verfahr- und Bewegungsbereiche für den Bediener erkennbar zu machen.

4. Verfahren nach einem der vorhergehenden Ansprüche, **dadurch gekennzeichnet, dass** der Bediener beim virtuellen Robotmodell (21) bzw. beim physikalischen Roboter (5) auf der Robotersteuerung (17) die Möglichkeit hat, durch manuelle Veränderung von peripheren Zuständen, die Abfolge der Bewegungs- und Funktionssequenzen zu beeinflussen und somit Abläufe zu testen.

5. Verfahren nach einem der vorhergehenden Ansprüche, **dadurch gekennzeichnet, dass** das virtuelle Robotmodell (21) das Teachprogramm (20) in beschleunigter Zeit, also in Zeitraffer, abarbeitet.

6. Verfahren nach einem der vorhergehenden Ansprüche, **dadurch gekennzeichnet, dass** das virtuelle Robotmodell (21) derart betrieben wird, dass alle oder einige der möglichen Verzweigungen, die eine Teachprogrammabarbeitung nehmen kann, automatisiert erfasst und durchgetestet werden.

7. Verfahren nach einem der vorhergehenden Ansprüche, **dadurch gekennzeichnet, dass** der virtuelle Roboter (21) Teil einer virtuellen Arbeitszelle (2) ist und weitere Geräte der Arbeitszelle (2) wie Spritzgießmaschine (4), Entnahmegreifer (6), Angusszange, Förderband (8) und sonstige Peripherie- und Automatisierungskomponenten im Kontext des virtuellen Roboters (21) dargestellt werden und optional in der Validierung berücksichtigt werden können.

8. Verfahren nach einem der vorhergehenden Ansprüche, **dadurch gekennzeichnet, dass** in die Visualisierung der Arbeitszelle (2) gezoomt werden kann, wobei die Perspektive frei wählbar und jederzeit verändert werden kann.

9. Verfahren nach einem der vorhergehenden Ansprüche, **dadurch gekennzeichnet, dass** die Konfigurationsdatei (27) und das Teachprogramm (20) auf einen externen Rechner übertragen werden können und somit eine Offline-Überprüfung der Ablaufsequenz möglich ist.

10. Roboter (5) mit einer Robotsteuerung (17) zur Validierung von programmierten Ablaufsequenzen oder Teachprogrammen (20) eines Roboters (5), wobei der Roboter (5) auf oder neben einer Spritzgießmaschine (4), montiert ist und für die Entnahme, Handhabung, Manipulation oder Weiterbearbeitung von gerade produzierten Spritzgießteilen (3) ausgebildet ist, wobei der Roboter (5) zum Durchführen des Verfahrens nach einem oder mehreren der Ansprüche 1 bis 9 ausgebildet ist.

## Claims

1. Method for validating programmed sequences of operations or teach programs (20) of a robot (5) with a robot controller (17), wherein the robot (5) is mounted on or next to an injection-molding machine (4) and is used for the removal, handling, manipulation or further processing of injection-molded parts (3) which have just been produced, wherein traversing parameters, equipment features and functionalities of the physical robot (5) are stored on the controller side in a configuration file (27) and the robot controller (17) creates a virtual robot model (21) from these stored data and accesses the current teach program (20) in the robot controller (17) in order to validate a workflow sequence, wherein the visualization of the workflow sequence is displayed directly on an output unit of the robot controller (17), wherein the virtual robot model (21) is decoupled from the physical robot (5) in any command line of the teach program (20) and is used for validating certain commands and subsequences in the teach program (20) for potential collisions or misbehavior, wherein the virtual robot follows the physical robot (5) in the coupled state and upon decoupling this synchronization between virtual and physical robot (5) is stopped, wherein the coupled physical robot (5) executes the current program sequence up to a possible collision situation and only then switching over to the virtual robot model (21) with simulation of dangerous states takes place, wherein the virtual robot (5) is coupled again with the physical robot (5) at any time after decoupling and is reset to the initial state in order to subsequently validate further subsequences of the teach program (20).

2. Method according to claim 1, **characterized in that** the relevant dimensions of the processing machine and further components, in particular grippers (6) for manipulation of the injection-molded parts (3), conveyor belts (8), automation systems, mills, protective enclosures (25), etc., which together with the physical robot (5) form a work cell (2) and are designed for interaction with the robot (5), are either transmitted digitally to the robot controller (17) or queried or determined, respectively, with the aid of measuring devices (32), and are included by the robot controller (17) into the validation for detection of possible collision states.

3. Method according to any one of the preceding claims, **characterized in that** programmed or determined movement spaces (31) of the physical robot (5) are represented spatially and in color in the virtual robot model (21) in order to make permitted travel and movement areas recognizable for the operator.

4. Method according to any one of the preceding claims, **characterized in that** the operator has the possibility, in the virtual robot model (21) or in the physical robot (5) on the robot controller (17), respectively, to influence the sequence of the movement and function sequences by manually changing peripheral states and thus to test workflows.

5. Method according to any one of the preceding claims, **characterized in that** the virtual robot model (21) executes the teaching program (20) in accelerated time, i.e. in fast motion.

6. Method according to any one of the preceding claims, **characterized in that** the virtual robot model (21) is operated in such a way that all or some of the possible branchings that execution of a teaching program can take are automatically detected and thoroughly tested.

7. Method according to any one of the preceding claims, **characterized in that** the virtual robot (21) is part of a virtual work cell (2) and further devices of the work cell (2) such as injection-molding machine (4), extraction gripper (6), sprue gripper, conveyor belt (8) and other peripheral and automation components are represented in the context of the virtual robot (21) and can optionally be taken into account in the validation.

8. Method according to any one of the preceding claims, **characterized in that** it is possible to zoom into the visualization of the work cell (2), wherein the perspective can be freely selected and changed at any time.

9. Method according to any one of the preceding claims, **characterized in that** the configuration file (27) and the teaching program (20) can be transferred to an external computer, thus allowing off-line checking of the workflow sequence.

10. Robot (5) with a robot controller (17) for validating programmed sequences of operations or teach programs (20) of a robot (5), wherein the robot (5) is mounted on or next to an injection-molding machine (4) and is designed for the removal, handling, manipulation or further processing of injection-molded parts (3) which have just been produced, wherein
the robot (5) is designed for carrying out the method according to one or several of claims 1 to 9.

## Revendications

1. Procédé pour la validation de séquences de déroulement programmées ou des programmes d'apprentissage (20) d'un robot (5) avec une commande de robot (17), le robot (5) étant monté sur ou à côté d'une presse d'injection (4) et servant pour le prélèvement, le maniement, la manipulation ou le traitement ultérieur de pièces moulées par injection (3) qui viennent d'être produites, les paramètres de translation, les caractéristiques d'équipement et les fonctionnalités du robot (5) physique étant enregistrés côté commande dans un fichier de configuration (27) et la commande de robot (17) créant un modèle de robot virtuel (21) à partir de ces données enregistrées et recourant au programme d'apprentissage (20) actuel dans la commande de robot (17), la visualisation de la séquence de déroulement étant affichée directement sur une unité de sortie de la commande de robot (17), le modèle de robot virtuel (21) étant découplé dans n'importe quelle ligne de commande du programme d'apprentissage (20) du robot (5) physique et étant utilisé pour la validation de certaines commandes et séquences partielles dans le programme d'apprentissage (20) pour détecter des collisions potentielles ou des mauvais comportements, le robot virtuel suivant le robot (5) physique à l'état couplé, cette synchronisation étant arrêtée en cas de découplage entre le robot virtuel et le robot (5) physique), le robot (5) physique couplé effectuant le déroulement du programme actuel jusqu'à une situation éventuelle de collision et basculant seulement sur le modèle de robot virtuel (21) avec reconstitution de situations dangereuses, le robot (5) virtuel étant à tout moment à nouveau couplé avec le robot (5) physique après le découplage et remis dans l'état initial afin de valider ensuite d'autres séquences partielles du programme d'apprentissage (20).

2. Procédé selon la revendication 1, **caractérisé en ce que** les dimensions pertinentes de la machine de traitement et d'autres composants, notamment le préhenseur (6) pour la manipulation des pièces moulées par injection (3), les convoyeurs à bandes (8), les installations d'automatisation, les broyeurs, les enceintes de protection (25), etc., qui constituent une cellule de travail (2) avec le robot (5) physique et qui sont conçus pour l'interaction avec le robot (5), sont soit transmises de manière numérique à la commande de robot (17) ou interrogées, soit déterminées à l'aide de dispositifs de mesure (32), et prises en compte dans la validation par la commande de robot (17) pour la détection d'éventuelles états de collision.

3. Procédé selon l'une des revendications précédentes, **caractérisé en ce que** les espaces de mouvement (31) programmés ou déterminés du robot (5) physique sont représentés dans l'espace et en couleur dans le modèle de robot virtuel (21), afin de rendre identifiables les zones de déplacement et de mouvement autorisés pour l'opérateur.

4. Procédé selon l'une des revendications précédentes, **caractérisé en ce que** l'opérateur a la possibilité d'influencer la succession des séquences de mouvement et de fonctions et de tester ainsi les déroulements au moyen de la commande de robot (17) du modèle de robot virtuel (21) ou du robot (5) physique par la modification manuelle de conditions périphériques.

5. Procédé selon l'une des revendications précédentes, **caractérisé en ce que** le modèle de robot virtuel (21) exécute le programme d'apprentissage (20) de manière accélérée.

6. Procédé selon l'une des revendications précédentes, **caractérisé en ce que** le modèle de robot virtuel (21) est exploité de telle sorte que toutes ou certaines des ramifications éventuelles, qu'une exécution du programme d'apprentissage peut prendre, soient saisies ou testées de manière automatisée.

7. Procédé selon l'une des revendications précédentes, **caractérisé en ce que** le robot virtuel (21) fait partie d'une cellule de travail (2) virtuelle et que d'autres appareils de la cellule de travail (2) tels que la presse d'injection (4), le préhenseur de prélèvement (6), la pince à injection, le convoyeur à bande (8) et d'autres composants de périphérie et d'automatisation sont représentés dans le contexte du robot virtuel (21) et peuvent être pris en compte de manière optionnelle dans la validation.

8. Procédé selon l'une des revendications précédentes, **caractérisé en ce qu'**il est possible de zoomer sur la visualisation de la cellule de travail (2), la perspective pouvant être sélectionnée librement et être modifiée à tout moment.

9. Procédé selon l'une des revendications précédentes, **caractérisé en ce que** le fichier de configuration (27) et le programme d'apprentissage (20) peuvent être transférés sur un ordinateur externe et qu'une vérification de la séquence de déroulement est possible hors ligne.

10. Robot (5) avec une commande de robot (17) pour la validation des séquences de déroulement programmées ou des programmes d'apprentissage (20) d'un robot (5), le robot (5) étant monté sur ou à côté de la presse d'injection (4), et conçu pour le prélèvement, le maniement, la manipulation ou le traitement ultérieur de pièces moulées par injection (3) qui viennent d'être produites,
le robot (5) étant conçu pour l'exécution du procédé selon une ou plusieurs des revendications 1 à 9.
